# EUROPEAN PATENT APPLICATION

(11) **EP 1 128 546 A1**
(43) Date of publication of application: **29.08.2001**
(21) Application number: 00103444.6
(22) Date of filing: 28.02.2000
(51) Int. Cl.: H03D 7/14

(54) **Upconverter mixer circuit**

(71) Applicant: DEUTSCHE THOMSON-BRANDT GMBH, 78048 Villingen-Schwenningen (DE)
(72) Inventor: Ipek, Mehmet, 78050 Villingen (DE); Blaud, Philippe, 78050 Villingen (DE); Rieger, Martin, 78628 Rottweil (DE); Schemann, Heinrich, 78052 Villingen (DE)

(57) **Abstract**

The upconverter mixer circuit comprises a Gilbert cell with an LC-resonator (L1, C1) tuned to the output frequency of the upconverter mixer circuit, and an output buffer. In a preferred embodiment the output buffer comprises a differential amplifier being emitter degenerated with inductances (L2, L3) for a low-pass characteristic. The LC-resonator of the Gilbert cell as well as the inductances of the output amplifier are integrated in an integrated circuit together with the other parts of the upconverter mixer circuit and provide a first selection within the integrated circuit for the subsequent stages, for example an intermediate frequency filter of a double conversion TV tuner. When the upconverter mixer circuit is operated with a strong DC-current and hard switching, which is necessary for achieving low noise, strong high frequency parasitic currents are also generated. These are mainly harmonics of the local oscillator frequency, which can be observed on the supply lines and input and output lines of the integrated circuit. The two stages of the upconverter mixer, the Gilbert cell followed by the output buffer, provide therefore a first intermediate filter to suppress parasitic currents within the upconverter mixer circuit. This enables to design a receiver with a large dynamic range and a high linearity, and having a low noise, by using a strong DC current and a hard mixer switching.

## Description

The invention refers to an upconverter mixer circuit for receiving a frequency band with a plurality of input frequency channels, comprising a Gilbert cell and an output buffer. Mixer circuits of this kind are used for example in double conversion TV tuners for converting video channels of cable and terrestrial television transmissions to a base band.

Double conversion TV tuners are known for example from US 5,847,612 and US 5,737,035, which describe circuits for converting video channels within a frequency band of 55 MHz - 806 MHz to a base band of about 20 MHz or 50 MHz. The double conversion TV tuners of these patents comprise an input filter and an input amplifier followed by a first mixing stage for upconverting the frequency band. After the upconversion an intermediate frequency filter follows for a coarse channel selection and for suppressing image frequencies. The output signal of this filter is downconverted by a second mixing stage to the base band, in which a base band filter selects the wanted channel for signal processing in the subsequent television stages.

In double conversion tuners of this kind the local oscillator frequency of the first mixing stage is varied for the channel selection and the second mixing stage works with a fixed or also variable local oscillator frequency, so that a fixed intermediate frequency filter can be used and an according base band filter. With the high intermediate frequency the image frequency band is far away from the input RF band which relaxes selectivity requirements for the image rejection filters. This allows an adjustment free production of the TV tuner.

In US 5,625,307 a monolithic upconverter circuit is described which performs a first frequency conversion of a double conversion TV tuner. The upconverter circuit includes a Gilbert type image-rejection mixer, which comprises image-rejection inductors to improve the noise figure of the mixer. A mixer with a Gilbert cell is a double balanced mixer found in many integrated circuits, which has excellent carrier suppression and low second order distortion, but suffers from high noise figure.

From US patent 5,675,392 a mixer with a Gilbert cell is known for converting video signals to an output signal. The Gilbert cell is used for mixing two differential input signals in a predetermined ratio, which is controlled by a control signal for specifying the ratio of the two input signals.

Because of the large input bandwidth of the upconverter mixer circuit and the associated limited frontend selection of the input image rejection filters a local oscillator voltage with a high DC-current and a hard switching is necessary to improve the noise figure. This has the disadvantage that strong high frequency currents are generated in the mixer, especially at 2 x f_{LO}, which then give raise to instability and isolation problems within the double conversion tuner.

It is the object of the present invention to provide an upconverter mixer circuit with a stable operation and a good noise performance.

This object is achieved by means of the features of the invention as specified in claim 1. Advantageous developments of the invention are specified in the subclaims. In claim 10 an application of the upconverter mixer circuit for a double conversion tuner is disclosed.

According to the invention, the upconverter mixer circuit comprises a Gilbert cell with an LC-resonator tuned to the output frequency of the upconverter mixer circuit, and an output buffer. In a preferred embodiment the output buffer comprises a differential amplifier being emitter degenerated with on-chip inductances for a low-pass characteristic.

The LC-resonator of the Gilbert cell as well as the inductances of the output amplifier can be integrated in an integrated circuit together with the other parts of the upconverter mixer circuit and provides therefore a first selection within the integrated circuit for the following stages, for example an intermediate frequency filter of a double conversion TV tuner. When the upconverter mixer circuit is operated with a strong DC-current and hart switching, which is necessary for a achieving both a high linearity and a low noise, strong high frequency parasitic currents are also generated. These are mainly harmonics of the local oscillator frequency, which can be observed on the supply lines and input and output lines of the integrated circuit. The two stages of the upconverter mixer, the Gilbert cell followed by the output buffer, provide therefore a first intermediate filter to suppress parasitic currents within the upconverter mixer circuit. Therefore, the parasitic high frequency switching currents, especially at twice the local oscillator frequency, are kept on-chip and do not flow through the bond wires and the pins of the integrated circuit. This enables to design a receiver with a large dynamic range and a high linearity, having low noise, by using a strong DC current and a hard mixer switching.

In a preferred embodiment, the inductance of the LC-resonator is arranged within the voltage feed of the Gilbert cell, using an inductor with a tap, to which the supply voltage is coupled. The other ends of the inductor are connected to the transistors of the Gilbert cell. The capacitance of the LC-resonator is coupled in parallel to the inductance. Due to the ohmic losses of the components of the LC-resonator, the LC-resonator has a quality factor Q, which is comparatively low and does not require any tuning of the LC-resonator. There is no DC voltage drop across the LC-resonator which enables to make sufficient gain even at a low supply voltage.

In a further preferred embodiment, the output buffer comprises a differential amplifier, which inputs are coupled to the LC-resonator of the Gilbert cell, being emitter degenerated with on-chip inductivities in order to achieve a high linearity together with a low noise. The lowpass characteristic of the emitter degenerated differential amplifier provides a further selection for a subsequent intermediate frequency filter.

The invention is explained in more detail with reference to a schematic drawing showing a preferred embodiment, in which is shown:

Figure: Upconverter mixer circuit comprising a Gilbert cell and an output buffer.

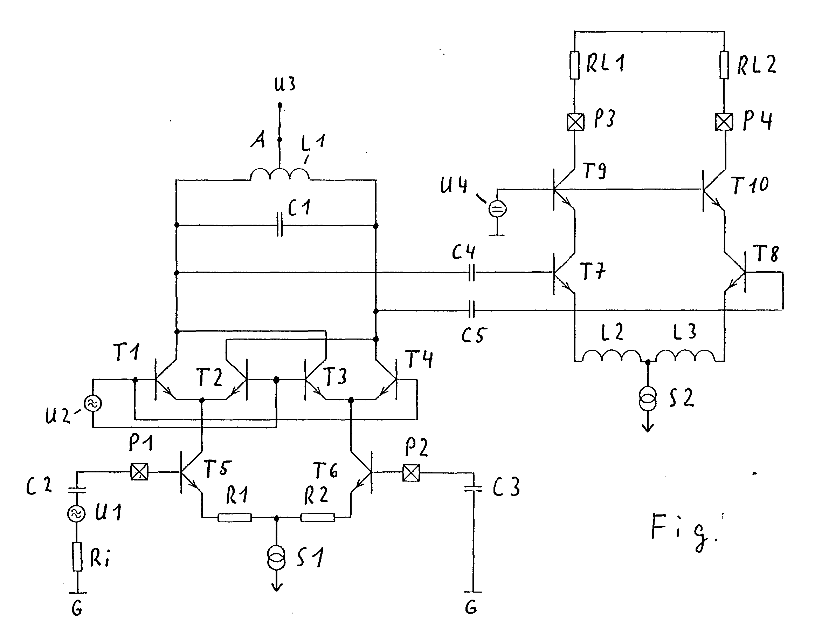

The Gilbert cell of the sole figure comprises a first differential amplifier with two transistors T5, T6, which emitters are coupled via two resistors R1, R2 and which are driven by a current source S1. The current source S1 provides a constant current for the differential amplifier T5, T6 and the subsequent transistors T1 - T4 of the Gilbert cell. The transistors T1 - T4 are arranged as two pairs of emitter-coupled differential amplifiers, which pairs are each coupled with its emitters to a collector of the transistors T5, T6 of the differential amplifier. The collectors of the transistors T1 - T4 are coupled to a supply voltage U3 and to an output buffer with transistors T7 - T10. To the bases of the transistors T1 - T4 a local oscillator frequency U2 is coupled.

The Gilbert cell together with the subsequent output buffer are arranged within an integrated circuit which comprises pins 1 - 4 for providing connections to a printed circuit board. The pin 1 is coupled to the base of the transistor T5 of the differential amplifier T5, T6, and to an input voltage U1 with a source impedance Ri via a capacitor C2. The pin P2 is coupled to the base of the second transistor T6 of the differential amplifier for coupling this base via a capacitor C3 to ground G. The differential amplifier T5, T6 works therefore as an input amplifier for the input voltage U1 providing a voltage to current conversion for the subsequent transistor stages T1-T4 of the Gilbert cell. Because of the differential amplifier arrangements of the transistors T1 - T6, the Gilbert cell works as a double balanced mixer. The two differential switches with transistors T1, T2 and T3, T4 are equivalent, but are operating in a push-pull manner for the output signal of the first differential amplifier T5, T6.

Between the supply voltage U3 and the collectors of the four transistors T1 - T4 an LC-resonator with an inductance L1 and a capacitance C1 in parallel to the inductor L1 is arranged. The supply voltage U3 is advantageously coupled to a tap A of the inductor L1 splitting it into two parts which each work as a collector impedance for the subsequent transistor stages. The resonance frequency of the LC-resonator L1, C1 is tuned to the output frequency of the Gilbert cell, for example to the frequency of a subsequent intermediate frequency filter.

In this application, the upconverter mixer translates the wideband RF frequency input range of 50 - 860 MHz of the terrestrial and cable frequency ranges to a fixed higher intermediate frequency IF, for example 1224 MHz. The required local oscillator frequency range therefore is 1274 - 2084 MHz (RF + IF), which is less than one octave and which can be span with a single oscillator. The image frequency band is 2498 - 3308 MHz (RF + 2x IF). The LC-resonator L1, C1 provides a band bass filtering at the intermediate frequency of 1224 MHz and performs a first image rejection for the subsequent stages. By a subsequent mixer within a double conversion TV tuner a down conversion to the usual 40 MHz TV intermediate frequency is provided.

Because the LC resonator L1, C1 is integrated into an integrated circuit, the quality factor Q is about 7 - 8, maximum 10, mainly due to ohmic losses in this frequency range, for providing a first selection for the subsequent stages. Because the quality factor Q is not too high, the tolerances of the on-chip capacitance C1 and the inductance L1 are acceptable, so that no special tuning of the LC resonator is required. If necessary, a resistor can be placed in parallel to the capacitor C1 to reduce the quality factor Q slightly.

The quality factor Q has to be set carefully to keep the noise and linearity trade-off of the subsequent stages feasible. A high Q provides enough gain which relaxes the noise requirement of the output buffer but makes the requirements on linearity more severe. Therefore a moderate Q is preferable to be able to cope with technology dispersion, typically up to 10 to 20 % of the absolute C and L values, because, even if the LC resonance frequency is not exactly centered, the transfer characteristic is then flat enough not to reduce the gain and linearity to much. Because there is no DC voltage drop across the inductor L1 of the LC resonator, the Gilbert cell provides a good gain even at a comparatively low supply voltage U3, for example 5 Volts.

To the LC resonator L1, C1 an output buffer with a differential amplifier stage comprising transistors T7, T8 is coupled which is emitter degenerated by using two inductivities L2, L3, to which a common current source S2 is coupled. The differential amplifier provides therefore an amplification with a lowpath characteristic, which cut-off frequency is tuned well above the intermediate frequency IF. The bases of the transistors T7, T8 are each coupled via capacitors C4, C5 to the parallel circuit of the LC resonator L1, C1, to avoid a DC coupling.

To the collectors of the transistors T7, T8 a cascode circuit with transistors T9 and T10 is coupled for providing a good isolation for the output voltage. The bases of both transistors are coupled to a voltage U4, which is constant. The collectors of the transistors T9, T10 are coupled to pins P3 and P4 of the integrated circuit to provide an external output signal to an output load RL1, RL2 and/or to an intermediate frequency filter, which is usually a ceramic filter, and which cannot be incorporated into an integrated circuit.

The output buffer is emitter degenerated with on-chip inductances in order to achieve a high linearity together with a low noise. The bandpath characteristic of the Gilbert cell with the LC resonator and the lowpath characteristic of the subsequent output buffer provide therefore a good selection for a following mixer stage. Compared to a Gilbert mixer with open collector outputs, this architecture with the internal LC load and the subsequent cascoded output buffer avoids strong high frequency currents, especially at 2 x LO generated by the mixer switching, flowing through bond wires and pins of the integrated circuit. These currents are thus kept on-chip and do not find a return path to the source input voltage or output voltage of the package, which improves stability and isolation.

The upconverter mixer circuit should be driven by a local oscillator voltage U2 having steep transitions, ideally a square wave, in order to have fast commutations, which limit the noise degradation caused by the switching action. This is necessary to achieve the required high dynamic range with a good noise and linearity performance across the whole wideband RF input range. The only way to realise this is to use a strong DC-current for the local oscillator voltage U2, in the order of magnitude of a few 10 mA for a TV tuner application. When the switching stage, transistors T1-T4 of the upconverter mixer circuit, is toggled, it acts as a cascode and has little influence on noise, while in the transition phase near equilibrium it works as an amplifier and heavily contributes to the noise seen at the Gilbert cell output, by amplifying the noise of its driving source and of its own base resistance. Furthermore, in this transition phase the current flow is interrupted.

The strong DC-current and hard switching of the upconverter mixer circuit necessary for achieving both a high linearity and a low noise have the drawback that strong high frequency parasitic currents are also generated. The main one appears at the switching frequency of twice the local oscillator frequency, but also other common-mode currents, especially at even higher harmonics of the local oscillator frequency are generated and can be observed on the supply lines of a double balanced mixer. This problem is worsen by the fact that, to fulfil its high performance requirements, the upconverter mixer circuit is implemented using a highfrequency bipolar or SiGe process, of which transistors have a high f_{T}, in the range of a few 10 GHz, and thus a high AC current gain β=f_{T}/f at these critical frequencies 2n^{*}LO exists.

These parasitic currents, especially at the switching frequency 2^{*}LO can generate oscillations in bond wires which can pollute the whole integrated circuit. It is therefore advantageous to keep the supply voltage lines quiet by using for them a few pins connected in parallel. Also critical pins like the input RF voltage inputs, pin P1, and the intermediate frequency outputs, pins P3, P4, should be short symmetrical ones to limit their impedance and ensure that the differential terms of the parasitic currents compensate for each other. In addition, capacitors can be arranged between the pins P1 and P2 and/or between the base and the collector of each the transistors T5, T6 to suppress the parasitic currents further.

Within the upconverter mixer circuit different configurations are possible for the Gilbert cell. The upconverter mixer circuit according to the figure comprises a first differential common-emitter amplifier with transistors T5, T6 for converting the single ended input voltage U1 into a differential current signal for the mixer stage with the transistors T1-T4. If low-selectivity tuneable bandpath filters are placed in front of the upconverter mixer circuit to relax intermodulation frequency requirements, a single balanced mixer with a common-emitter or common-base amplifier transistor can be used also. Also, a special input impedance matching can influence the design of the input stage of the upconverter mixer circuit.

The upconverter mixer circuit can be used especially as a first stage within a double conversion TV tuner for providing the upconversion of the input frequency range. The bandpath characteristic of the LC-resonator L1, C1 and the low-pass characteristic of the output buffer with transistors T7 to T10 is then tuned to the intermediate frequency IF of a subsequent intermediate frequency filter of the double conversion tuner. In a next stage, the double conversion tuner comprises a downconverter mixer circuit for downconverting the intermediate frequency IF to a base band of a television receiver.

## Claims

1. Upconverter mixer circuit for receiving a frequency band with a plurality of input channels, comprising a Gilbert cell and an output buffer, characterized in that the Gilbert cell (T1 - T6, R1, R2, S1) comprises an LC-resonator (L1, C1) tuned to the output frequency.

2. Upconverter mixer circuit according to claim 1, characterized in that the output buffer (T7-T10, L2, L3, S2) comprises a differential amplifier (T7, T8, L2, L3, S3) coupled to the LC-resonator (L1, C1).

3. Upconverter mixer circuit according to claim 1 or 2, characterized in that the LC-resonator (L1, C1) is integrated together with the Gilbert cell (T1-T6, R1, R2, S1) and the output buffer (T5-T8, L2, L3, S2) in an integrated circuit.

4. Upconverter mixer circuit according to one of the preceding claims, characterized in that the LC-resonator (L1, C1) is arranged within the voltage feeding of the supply voltage (U3) of the Gilbert cell (T1-T6, R1, R2, S1).

5. Upconverter mixer circuit according to claim 4, characterized in that the inductance (L1) of the LC-resonator (L1, C1) is split into two parts by a tap (A), to which the supply voltage (U3) is coupled, and which are arranged each in series of one of the voltage supply lines of the Gilbert cell (T1-T6, R1, R2, S1), and that the capacitor (C1) is arranged in parallel to the inductor (L1).

6. Upconverter mixer circuit according to one of the preceding claims 2 to 5, characterized in that the differential amplifier (T5, T6, L2, L3, S2) is emitter-degenerated with on-chip inductances (L2, L3) for a low-pass characteristic.

7. Upconverter mixer circuit according to claim 6, characterized in that the output buffer (T7 - T10, L2, L3, S2) comprises a cascode circuit (T7, T8) as an output stage.

8. Upconverter mixer circuit according to one of the preceding claims, characterized in that as the local oscillator voltage (U2) a near square wave voltage is used.

9. Upconverter mixer circuit according to one of the preceding claims, characterized in that the input voltage (U4) is applied to one of the inputs (P1) of the differential amplifier stage (T5, T6, R1, R2, S2) of the Gilbert cell (T1 - T6, R1, R2, S1), and that the local oscillator voltage (U2) is applied in parallel to the four inputs of the subsequent transistor stages (T1 - T4) of the Gilbert cell (T1 - T6, R1, R2, S1).

10. Double conversion tuner comprising an intermediate frequency filter and a downconverter, characterized in that it comprises further an upconverter mixer circuit according to one of the preceding claims, and that the bandpass characteristic of the LC-resonator (L1, C1) and the lowpass characteristic of the output buffer (T7 - T10, L2, L3, S2) of the upconverter mixer circuit are tuned to the intermediate frequency of the double conversion tuner.
